# EUROPÄISCHE PATENTANMELDUNG

(11) **EP 1 170 785 A2**
(43) Veröffentlichungstag der Anmeldung: **09.01.2002**
(21) Anmeldenummer: 01115186.7
(22) Anmeldetag: 22.06.2001
(51) Int. Cl.: H01L 21/302, H01L 21/205, H01L 21/02, H01L 21/306

(54) **Vefahren zum Erzeugen von Mikro-Rauhigkeiten auf einer Oberfläche**

(30) Priorität: 07.07.2000 DE 10034005
(71) Anmelder: Infineon Technologies AG, 81669 München (DE)
(72) Erfinder: Förster, Matthias, 01099 Dresden (DE); Morgenschweiss, Anja, Dr., 01108 Dresden (DE); Martini, Torsten, Dr,, 01309 Dresden (DE); Sachse, Jens-Uwe, Dr., 01099 Dresden (DE)
(74) Vertreter: Kindermann, Peter, Dipl.-Ing.

(57) **Zusammenfassung**

Die Erfindung betrifft ein Verfahren zum Erzeugen von Mikro-Rauhigkeiten an einer Oberfläche(2), wobei ein fein verteiltes Ausbilden von Halbleiter-Körnern (1) aus einem Prozessgas (P) an der Oberfläche (2) in einem einzigen Schritt erfolgt. Dadurch ergibt sich bei der Herstellung sowohl eine Zeit- als auch Kostenersparnis.

## Beschreibung

Die vorliegende Erfindung bezieht sich auf ein Verfahren zum Erzeugen von Mikro-Rauhigkeiten auf einer Oberfläche und insbesondere auf ein Verfahren zum Erzeugen von Mikro-Rauhigkeiten in einem Grabenkondensator einer Halbleiter-Speicherzelle.

In den letzten Jahren wurde die Zellgröße von Halbleiterspeichern fortlaufend verringert und somit die Integrationsdichte erhöht.

Kapazitäten von Halbleiter-Speicherzellen hängen von einer Vielzahl von unterschiedlichen Parametern ab, wobei ein Parameter die Kondensatoroberfläche darstellt. Mit zunehmender Integrationsdichte und damit einhergehenden abnehmenden Strukturgrößen ist zur Erhaltung einer technisch notwendigen Mindest-Speicherkapazität üblicherweise auch die Erhaltung einer ausreichenden Kondensatoroberfläche auf immer kleiner werdendem Raum erforderlich.

Eine derartige Oberflächenvergrößerung erhält man beispielsweise im Falle der sogenannten "Deep-Trench-Technologie", bei der die Kondensatoren in tiefen Gräben im Halbleitersubstrat ausgebildet werden, durch tieferes Ätzen der Gräben und/oder durch eine Aufweitung in ihrem unteren Bereich. Ein weitergehendes tiefer Ätzen der Gräben ist jedoch wirtschaftlich und technologisch sehr aufwändig, weshalb es für eine Massenfertigung kaum in Frage kommt. Andererseits ist die Möglichkeit zur Aufweitung der Gräben in ihren unteren Bereichen durch benachbarte Gräben lateral begrenzt, weshalb eine weitergehende Integration nicht beliebig möglich ist.

Im Falle der "Stack-Technologie" ist eine weitere Oberflächenvergrößerung mit einem sogenannten HSG-Prozess gebräuchlich. Dieser HSG-Prozess stellt ein relativ aufwändiges Verfahren zum Erzeugen von Mikro-Rauhigkeiten auf einer Oberfläche dar, wobei im Wesentlichen in drei aufeinanderfolgenden Prozessschritten zunächst eine Abscheidung von amorphem Silizium, anschließend ein sogenanntes "Seeding" zum Ausbilden von Keimzellen auf der amorphen Siliziumschicht und abschließend ein Ausheilen erfolgt, bei dem Si-Körner bzw. -Tröpfchen unter Verwendung der Keimzellen und durch Umwandlung bzw. Abbau der amorphen Siliziumschicht ausgebildet werden. Die auf diese Weise erzeugte Mikro-Rauhigkeit führt zwar zu einer deutlichen Oberflächenvergrößerung, das Verfahren ist jedoch kostspielig und zeitaufwändig.

Der Erfindung liegt daher die Aufgabe zu Grunde, ein Verfahren zum Erzeugen von Mikro-Rauhigkeiten auf einer Oberfläche zu schaffen, das auf einfache und zeit- sowie kostengünstige Art und Weise realisierbar ist.

Erfindungsgemäß wird diese Aufgabe durch die Maßnahmen des Patentanspruchs 1 gelöst.

Insbesondere durch ein fein verteiltes Ausbilden von Halbleiter-Körnern aus einem Prozessgas in einem einzigen Schritt vereinfacht sich das Verfahren wesentlich, wodurch sich sowohl eine Zeit- als auch Kostenersparnis ergibt.

Vorzugsweise werden Si-Körner mittels eines Silan-haltigen Prozessgases an der Oberfläche ausgebildet. Es können jedoch auch Ge-Körner mittels eines German-haltigen Prozessgases ausgebildet werden.

Vorzugsweise werden die Halbleiter-Körner in einem Temperaturbereich von 500 bis 600 Grad Celsius bei einem Druck von 100 bis 600 mTorr bei Abscheidezeiten von 5 bis 60 Minuten ausgebildet. Bei geeigneten Bedingungen kann ein Aufwachsen der amorphen Schicht und ein nachfolgendes Ausheilen entfallen, wobei die Halbleiter-Körner unmittelbar aus der Gasphase an der Oberfläche ausgebildet werden. Insbesondere bei Grabenkondensatoren kann dadurch eine unnötige Verengung der Gräben auf Grund der amorphen Schicht vermieden werden, wodurch sich weitere "Shrinks" ermöglichen lassen. Ferner kann mit den vorstehend beschriebenen herkömmlichen Verfahren zur Oberflächenvergrößerung wie z.B. Aufweiten der Gräben oder weitergehendes Vertiefen in Kombination mit dem erfindungsgemäßen Verfahren eine zusätzliche Kapazitätsvergrößerung ermöglicht werden. Auf Grund der unproblematischen Prozessparameter kann ferner ein kostengünstiger "Batch-Prozess" realisiert werden, bei dem eine Vielzahl von Wafern gleichzeitig bearbeitet werden. Darüber hinaus können gewöhnliche LPCVD-Anlagen ohne Probleme genutzt werden, wodurch sich insbesondere mit der relativ geringen Prozesszeit wesentliche Einsparungen bei der Herstellung realisieren lassen.

In den weiteren Unteransprüchen sind weitere vorteilhafte Ausgestaltungen der Erfindung gekennzeichnet.

Die Erfindung wird nachstehend anhand von Ausführungsbeispielen unter Bezugnahme auf die Zeichnung näher beschrieben.

Es zeigen:
- Figur 1: eine rasterelektronenmikroskopische Aufnahme einer Oberfläche mit Mikro-Rauhigkeiten und tiefen Gräben gemäß der vorliegenden Erfindung;
- Figur 2: eine vereinfachte Schnittansicht eines Prozessofens zum Realisieren des erfindungsgemäßen Verfahrens;
- Figur 3: eine graphische Darstellung einer Kornhöhe und eines Kornabstands bei verschiedenen Abscheidezeiten;
- Figur 4: eine graphische Darstellung der Kornhöhe und des Kornabstandes in Abhängigkeit von einer Abscheidetemperatur;
- Figur 5: eine graphische Darstellung der Kornhöhe und des Kornabstandes in Abhängigkeit von einem Verdünnungsverhältnis und der Abscheidezeit;
- Figur 6: eine graphische Darstellung der Kornhöhe und des Kornabstandes in Abhängigkeit vom Verdünnungsverhältnis, der Abscheidezeit und einer Oberflächenart;
- Figur 7: eine graphische Darstellung der Kornhöhe und des Kornabstandes in Abhängigkeit von einer Vorreinigung; und
- Figur 8: eine graphische Darstellung einer Oberflächenvergrößerung in Abhängigkeit von einem relativen Kornabstand gemäß einem idealen Modell.

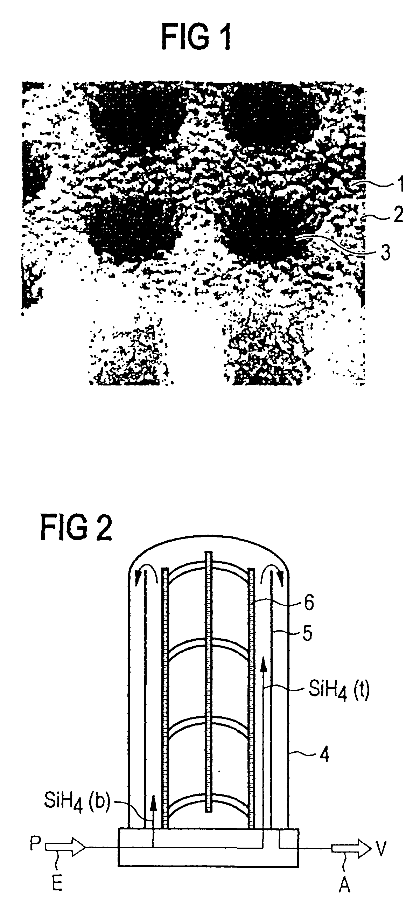

Figur 1 zeigt eine rasterelektronenmikroskopische Aufnahme einer Oberfläche 2 mit tiefen Gräben 3, wie sie beispielsweise zum Ausbilden von Grabenkondensatoren in DRAM-Halbleiter-Speicherzellen verwendet werden. Zur Vergrößerung der Oberfläche 2 befinden sich gemäß Figur 1 eine Vielzahl von Halbleiter-Körnern 1 auf der Waferoberfläche und innerhalb der Gräben 3. Die durch die Vielzahl von Halbleiter-Körnern 1 hervorgerufene Mikro-Rauhigkeit der Oberfläche 2 vergrößert somit unmittelbar eine Kapazität eines in den Gräben 3 ausgebildeten Grabenkondensators. Die Halbleiter-Körner 1 werden hierbei in einem einzigen Verfahrensschritt an der Oberfläche 2 und in den Gräben 3 ausgebildet, wodurch sich im Gegensatz zum vorstehend beschriebenen herkömmlichen HSG-Prozess eine wesentliche Zeit- und Kostenersparnis ergibt.

Figur 2 zeigt eine vereinfachte Schnittansicht eines Prozessofens, wie er zur Durchführung des erfindungsgemäßen Verfahrens verwendet werden kann. Der in Figur 2 dargestellte LPCVD-Ofen (LPCVD, low pressure chemical vapor deposition) ist beispielsweise ein Ofen vom Typ AVP-8000 des Herstellers Silicon Valley Group. Der Aufbau dieses doppelwandigen Vertikalofens ist gemäß Figur 2 folgendermaßen: Ein äußeres Rohr 4 schließt eine Prozesskammer nach außen ab. Ein inneres Rohr 5 hat einen geringeren Durchmesser und liegt koaxial innerhalb des äußeren Rohres 4. Eine nicht dargestellte Heizung befindet sich außerhalb des äußeren Rohres 4. Ein sogenanntes Boot 6 dient zur Aufnahme der Wafer und wird in das innere Rohr 5 hineingefahren, nachdem es mit den Wafern beladen wurde.

Zuleitungen E für die verschiedenen Prozessgase P liegen im Sockelbereich. Als Prozessgas kann beispielsweise Silan (SiH₄) verwendet werden. Einlässe/Ausström-Öffnungen für das Prozessgas befinden sich im unteren sowie im oberen Bereich innerhalb des inneren Rohres 5, bezeichnet mit SiH₄(b) bzw. SiH₄(t). Das Prozessgas strömt im inneren Rohr 5 durch Zwischenräume zwischen den Wafern und an diesen vorbei nach oben, während ein geringer Anteil auf den heißen Oberflächen der Wafer und der Prozesskammer chemisch reagiert und zur Bildung der Halbleiter-Körner führt. Zwischen innerem Rohr 5 und äußerem Rohr 4 strömt das Prozessgas wieder nach unten und wird über einen Anschluss A zur Vakuumpumpe V abgesaugt. Üblicherweise wird Silan als Prozessgas verwendet, welches durch Trägergase oder Inertgase wie z.B. Stickstoff, Wasserstoff, Helium oder Argon verdünnt werden kann.

Der wesentliche Vorteil der vorliegenden Erfindung liegt insbesondere in der Verwendung eines derartigen herkömmlichen vertikalen Ofens und dem Ausbilden von fein verteilten Halbleiter-Körnern 1 aus dem Prozessgas P an der Oberfläche 2 in einem einzigen Schritt. Im Gegensatz zum vorstehend beschriebenen herkömmlichen HSG-Prozess wird demzufolge keine amorphe Schicht ausgebildet und auch kein anschließendes "Seeding" und Ausheilen durchgeführt, sondern die Halbleiter-Körner 1 werden unmittelbar bei Drücken abgeschieden bzw. ausgebildet, wie sie bei LPCVD-Prozessen üblich sind. Dieses von den Erfindern überraschenderweise ermittelte Herstellungsverfahren zum Erzeugen von Mikro-Rauhigkeiten auf einer Oberfläche kann in einem einzigen Verfahrensschritt durchgeführt werden.

Nachfolgend wird eine Vielzahl von Versuchen zur Oberflächenvergrößerung mit Silizium-Körnern als Halbleiter-Körner 1 beschrieben, wobei jedoch in gleicher Weise auch Germanium-Körner ausgebildet werden können.

Zur Bestimmung einer Abhängigkeit der Kornhöhe und des Kornabstandes von einer Abscheidezeit wird diese in einer Reihe von Versuchen variiert, wobei der Druck bei 200 mTorr und die Temperatur bei 560 Grad Celsius festgehalten werden.

Die weiteren Prozessparameter sind 200 sccm (Normkubikzentimeter pro Minute) für SiH₄ (b), 100 sccm für SiH₄ (t), und 70 sccm für das Verdünnungsgas H₂. Bei allen Versuchen ist das Boot vollständig mit Wafern beladen. Die Prozessergebnisse werden auf Test-Wafern mit einer 30 nm dicken Oxidschicht ermittelt. Diese Test-Wafer werden hierbei in einer mittleren Position des vertikalen Ofens gemäß Figur 2 eingebracht. Bei einer Abscheidezeit von 19 Minuten 10 Sekunden wird hierbei eine minimale Kornhöhe von 55 nm und eine maximale Kornhöhe von 57 nm gemessen. Ferner wird bei einer derartigen Abscheidezeit eine geschlossene Schicht von ca. 30 nm ermittelt, die die Körner umschließt. Bei dieser Abscheidezeit und den dazugehörigen Prozessparametern ergibt sich folglich keine wesentliche Vergrößerung der Oberfläche.

In einem weiteren Versuch wird die Abscheidezeit (bei ansonsten gleichen Prozessparametern) auf 12 Minuten 40 Sekunden beschränkt, wobei eine minimale Kornhöhe von 48 nm und eine maximale Kornhöhe von 52 nm ermittelt wird. In diesem Fall wird ein Beginn der Schichtbildung zwischen den Körnern mit einer Dicke von ca. 5 bis 10 nm festgestellt.

Bei einer weiteren Verringerung der Abscheidezeit (bei ansonsten gleichen Prozessparametern) auf 9 Minuten 30 Sekunden ergibt sich eine minimale Kornhöhe von 35 nm und eine maximale Kornhöhe von 59 nm, wodurch einzelne Halbleiter-Körner dicht nebeneinander ausgebildet werden und eine deutliche Vergrößerung der Oberfläche eintritt.

Bei einer weiteren Verkürzung der Abscheidezeit auf 6 Minuten bei gleichen weiteren Prozessparametern ergibt sich eine minimale Kornhöhe von 21 nm und eine maximale Kornhöhe von 37 nm für einen Wafer im mittleren Bereich des vertikalen Ofens.

Folglich können einzelne Körner ausgebildet werden, wodurch sich eine wesentliche Vergrößerung der Oberfläche ergibt. Hierbei wurden bei ein und der selben "Ofenfahrt" zusätzliche Testwafer im oberen und unteren Bereich des Ofens eingeladen. Bei allen Versuchen ist stets das ganze Boot mit 120 bzw. 175 Wafern beladen, sogen. Dummy-Wafer, ausgewertet werden aber nur die Testwafer.

Der Test-Wafer im oberen Bereich des Ofens zeigt hierbei noch etwas größere Körner mit einer minimalen Höhe von 27 nm und einer maximalen Höhe von 42 nm. Im unteren Bereich des Ofens besitzt ein Wafer bei ansonsten gleichen Prozessparametern minimale Kornhöhen von 16 nm und maximale Kornhöhen von 28 nm, wobei eine geschlossene Schicht von ca. 12 nm Dicke die Körner umschließt und die Wafermitte rauher als der Waferrand wird. Ursache für die unterschiedlichen Prozessergebnisse an den verschiedenen Test-Wafer-Positionen ist die im inneren Rohr 5 von unten nach oben zunehmende Verdünnung des SiH₄ voriwegend aufgrund der Art der Zuführung des H₂ sowie in geringem Maße durch den zusätzlich entstehenden H₂ aus der chemischen Reaktion des SiH₄ (zu Silizium und Wasserstoff auf den heissen Oberflächen der Wafer und des inneren Rohres). Daraus ergibt sich, dass bei dem erfindungsgemäßen Einschritt-Prozess ein Verdünnungsverhältnis des SiH₄ zur Einstellung einer Halbleiter-Korngröße herangezogen werden kann.

Zur Beurteilung einer Temperaturabhängigkeit wird ein geneigtes Temperaturprofil eingestellt, und zwar im oberen Bereich eine Temperatur von 590 Grad Celsius, im mittleren Bereich eine Temperatur von 570 Grad Celsius und im unteren Bereich eine Temperatur von 550 Grad Celsius. Es werden hierbei drei Testwafer mit einer 30 nm dicken Oxidschicht verwendet, einer in jeder Temperaturzone.

In einem ersten Versuch wird eine starke H₂-Verdünnung des SiH₄ gewählt, wobei zusätzlich zur Temperatur auch die H₂-Verdünnung aus den bereits erwähnten Gründen von unten nach oben zunimmt. Der Gesamtfluss des Verdünnungsgases H₂ beträgt 800 sccm, der Fluss von SiH₄ (b) 40 sccm, von SiH₄ (t) 0 sccm. Der Druck wird auf 400 mTorr erhöht und eine Abscheidezeit von 30 Minuten gewählt. Auf Grund der Einflüsse sowohl der Verdünnung als auch der Temperatur ergibt sich folgendes Bild: im oberen Bereich des Ofens bzw. Bootes 6 (590 Grad Celsius) erhält man inselförmiges Schichtwachstum mit Dicken von minimal 13 bis maximal 28 nm. Es entsteht also keine geschlossene Schicht, sondern Inseln mit sehr ungleichmäßiger lateraler Ausdehnung. Im mittleren Bereich ergeben sich bei der Temperatur von 570 Grad Celsius und der abnehmenden H₂-Verdünnung Kornhöhen von minimal 28 bis maximal 33 nm, wodurch sich eine weitgehend geschlossene Schicht durch Koaleszenz bzw. Zusammenwachsen der Halbleiter-Körner einstellt. Erst im unteren Bereich bei einer Temperatur von 550 Grad Celsius ergeben sich Kornhöhen von minimal 40 bis maximal 50 nm, welche sehr eng beieinander liegen und eine relativ gleichmäßige Größe aufweisen.

Im einem zweiten Versuch zur Temperaturabhängigkeit wird, wiederum unter Verwendung eines geneigten Temperaturprofils, eine N₂-Verdünnung ausgewertet. Im Gegensatz zur Verdünnung mit H₂ wird hier das Verdünnungsgas bereits vor dem Eintritt in das Rohr mit SiH₄ gemischt. Dadurch ist das Verdünnungsverhältnis im gesamten Rohr nahezu konstant, und die Temperatur ist der maßgebliche Parameter, in welchem sich die drei Testwafer-Positionen unterscheiden. Der Fluss von SiH₄ (b) beträgt hierbei 40 sccm, von SiH₄ (t) 0 sccm und von N₂ 4000 sccm. Die Abscheidezeit liegt wiederum bei 30 Minuten, wobei ein Druck von 600 mTorr eingestellt wird. Im oberen Bereich ergeben sich bei einer Temperatur von 590 Grad Celsius Kornhöhen von minimal 31 bis maximal 46 nm, wobei eine weitgehende Koaleszenz der Halbleiter-Körner festgestellt wird, jedoch noch keine geschlossene Schicht entsteht. Im mittleren Bereich ergeben sich bei einer Temperatur von 570 Grad Celsius Kornhöhen von minimal 15 bis maximal 24 nm, wobei eine Koaleszenz der Halbleiter-Körner festgestellt wird, jedoch bereits mit mehr Lücken als bei 590 Grad Celsius. Im unteren Bereich des Ofens ergeben sich bei einer Temperatur von 550 Grad Celsius minimale Kornhöhen von ca. 5 nm bis maximale Kornhöhen von ca. 10 nm, wobei sehr kleine, einzelne Kügelchen mit gleichmäßiger Form, jedoch unterschiedlicher Größe ausgebildet werden. Daraus ergibt sich bei diesen Prozessbedingungen (Druck, Gasflüsse, Abscheidezeit) die geeignete Abscheidetemperatur von 560 Grad Celsius.

In einer weiteren Versuchsreihe wird bei Verwendung von N₂ als Verdünnungsgas eine Variation der Abscheidezeit, des Verdünnungsverhältnisses sowie der Art der Wafer-Oberflächen durchgeführt. Für eine 30 nm dicke Oxidoberfläche ergeben sich bei einem Fluss von 40 sccm SiH₄(b) und von 0 sccm SiH₄(t) sowie von 400 sccm N₂ bei einer Abscheidezeit von 15 Minuten, einem Druck von 200 mTorr und einer Temperatur von 560 Grad Celsius Kornhöhen von minimal 9 bis maximal 17 nm. Die Halbleiter-Körner stellten hierbei kleine einzelne Kügelchen mit gleichmäßiger Form und unterschiedlicher Größe dar. Um größere Körner zu erhalten, wurde in einer Variante die Zeit verlängert, in einer anderen die Verdünnung verringert. Bei beiden Varianten wurde das Kornwachstum auf Testwafern mit 30 nm Siliziumoxid- sowie 4,5 nm Siliziumnitrid-Oberflächen untersucht.

Bei einer Verlängerung der Abscheidezeit von 15 auf 30 Minuten und ansonsten gleichen Prozessparametern ergeben sich für die 30 nm Oxidoberfläche Kornhöhen von minimal 15 bis maximal 25 nm, wobei die Halbleiter-Körner teilweise zusammengewachsen sind und ungleichmäßige laterale Größen aufweisen. Auf der 4,5 nm dicken Nitridoberfläche bildet sich dagegen eine weitgehend geschlossene Schicht mit einzelnen Löchern. Die Dicke dieser Schicht liegt zwischen 19 und 26 nm.

Bei der zweiten Variante zur Vergrößerung der Körner wurde die Abscheidezeit bei 15 Minuten belassen, dafür aber die Verdünnung reduziert, indem der N₂-Fluss von 400 sccm auf 200 sccm zurückgenommen wurde. Die weiteren Prozessparameter wurden nicht verändert. Die sich ergebenden Kornhöhen betragen hierbei auf der Oxidoberfläche minimal 20 bis maximal 31 nm, wobei die Halbleiter-Körner teilweise zusammengewachsen sind, die laterale Größe gleichmäßiger ist und die Zwischenräume kleiner sind als bei bei der ersten Variante. Auf der Nitridoberfläche sind die Halbleiter-Körner sehr ähnlich ausgebildet wie auf der Oxidoberfläche, jedoch dicker, und die Zwischenräume noch kleiner. Es ergeben sich Kornhöhen von minimal 24 bis maximal 33 nm. Die Unterschiede im Aufwachsverhalten auf Oxid und Nitrid sind bei dieser Variante mit der schwächeren Verdünnung also geringer.

In einer weiteren Versuchsreihe wird der Einfluss von unterschiedlichen Vorreinigungsverfahren beim erfindungsgemäßen Verfahren zum Erzeugen von Mikro-Rauhigkeiten ermittelt. Hierbei wird an Stelle des Oxids bzw. Nitrids ein Silizium-substrat mit unterschiedlichen Vorreinigungen verwendet. Die Prozessparameter zum Erzeugen der Mikro-Rauhigkeiten an der Siliziumoberfläche werden auf einen SiH₄(b)-Fluss von 40 sccm, und N₂-Fluss von 200 sccm eingestellt. Die Abscheidezeit beträgt bei einer Temperatur von 560 Grad Celsius und einem Druck von 200 mTorr 15 Minuten. Bei einer sogenannten "Piranha"-Vorreinigung ergeben sich Kornhöhen von minimal 17 bis maximal 28 nm. Bei einer Vorreinigung mit "Piranha"- in Kombination mit einer sogenannten "RCA"-Vorreinigung ergeben sich Kornhöhen von minimal 14 bis maximal 24 nm. Ferner ergeben sich unter Verwendung einer Piranha- in Kombination mit einer sogenannten "HF-Dip"-Reinigung Kornhöhen von minimal 23 bis maximal 30 nm, wobei große unregelmäßige Halbleiter-Körner festgestellt werden.

Entgegen der herkömmlichen Erwartungen können somit überraschenderweise Mikro-Rauhigkeiten auf unterschiedlichen WaferOberflächen in einem einzigen Prozessschritt ausgebildet werden, und zwar bei Prozessdrücken, wie sie bei LPCVD-Prozessen üblich sind.

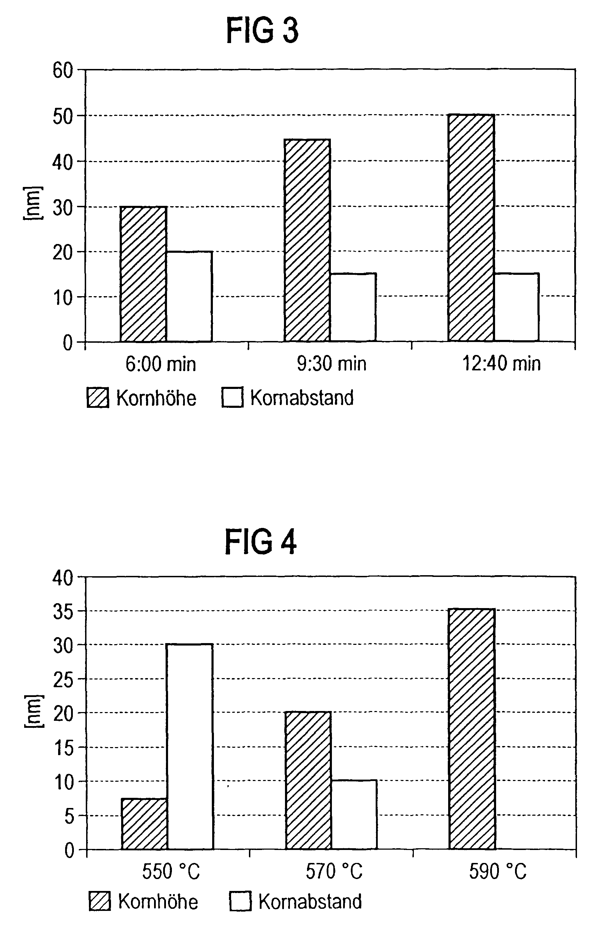

Die Figuren 3 bis 7 zeigen graphische Darstellungen zur zusammenfassenden Veranschaulichung der vorstehend beschriebenen Versuchsergebnisse. Es sei hierbei darauf hingewiesen, dass unter Kornhöhe der vertikale Abstand des höchsten Punktes eines Halbleiterkorns 1 von der darunter liegenden ebenen Waferoberfläche verstanden wird; bei einer geschlossenen Schicht ist dies gleich der Schichtdicke. In den nachfolgenden Diagrammen wird jeweils nur ein mittlerer Wert für die Kornhöhe bzw. Schichtdicke angegeben. Als Kornabstand wird hier der freie Abstand zwischen den seitlichen Oberflächen zweier benachbarter Körner bezeichnet. Ein Abstand gleich Null bedeutet, dass die Körner zusammengewachsen sind. Da in den nachfolgend beschriebenen Diagrammen jeweils ein mittlerer Abstand angegeben wird, bedeutet die Angabe "Null" noch nicht zwangsläufig eine glatte, geschlossene Schicht, sondern beschreibt auch eine überwiegende Koaleszenz der Körner.

Figur 3 zeigt eine graphische Darstellung der Kornhöhe und des Kornabstandes in Abhängigkeit von einer Abscheidezeit, wobei eine gleichbleibende H₂-Verdünnung von 1:0,2 vorliegt. Bei diesen Prozessbedingungen liefern Abscheidezeiten von 6 Minuten bis 12 Minuten 40 Sekunden noch ausreichende Versuchsergebnisse. Je nach Wahl der weiteren Parameter, die die Abscheiderate bzw. Bekeimungsrate bestimmen, insbesondere also der Verdünnung und der Temperatur, kann die Abscheidezeit derart eingestellt werden, dass einerseits ausreichend große Halbleiter-Körner gebildet werden und andererseits noch keine geschlossene Schicht aufwächst. Demzufolge können Abscheidezeiten von 5 Minuten bis 60 Minuten zu brauchbaren Ergebnissen führen.

Figur 4 zeigt eine graphische Darstellung der Kornhöhe und des Kornabstandes in Abhängigkeit von einer jeweiligen Prozesstemperatur.

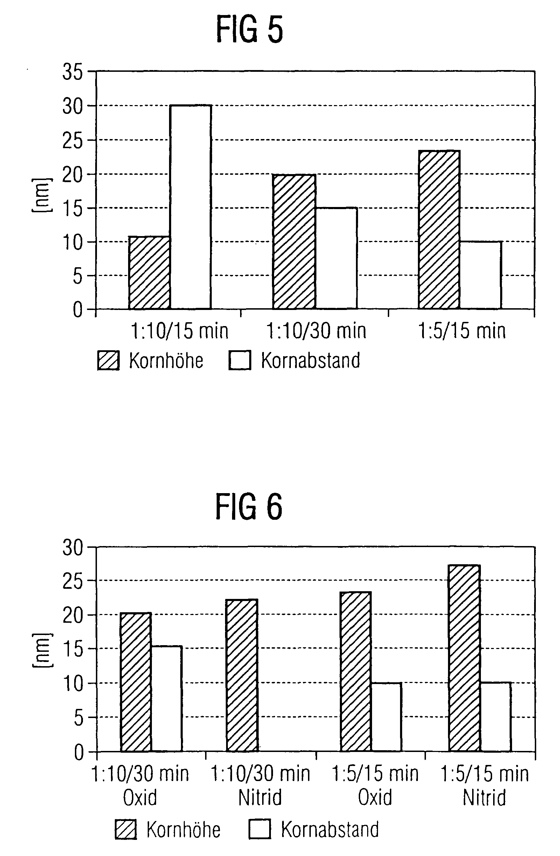

Ein derartiges geneigtes Temperaturprofil kann über getrennt regelbare Heizzonen im oberen, mittleren und unteren Bereich des Bootes 6 im Ofen 4 eingestellt werden. Bei einer Temperatur von 590 Grad Celsius ist gemäß Figur 4 eine weitgehende Koaleszenz der Halbleiter-Körner festzustellen, d.h. der mittlere Kornabstand beträgt Null. Bei ausreichend starker Verdünnung und nicht zu langer Abscheidezeit ist gemäß Figur 5 auch bei höheren Temperaturen mit der Bildung isolierter Körner zu rechnen. In Abhängigkeit von den weiteren Prozessparametern ergibt sich somit ein Temperaturbereich von 500 Grad Celsius bis 600 Grad Celsius, wobei vorzugsweise eine Temperatur von 560 Grad Celsius verwendet wird.

Gemäß Figur 5 sind die Kornhöhen und die Kornabstände bei unterschiedlichen Silan-Verdünnungen und Abscheidezeiten dargestellt. Die Versuchsreihe mit dem Parameter "1:10/15 Minuten" zeigt noch zu geringe Korngrößen und zu weite Abstände für eine effektive Oberflächenvergrößerung auf. Beides kann sowohl durch eine längere Abscheidezeit als auch durch eine schwächere Verdünnung des Silans gemäß Figur 5 verbessert werden. Es sei jedoch darauf hingewiesen, dass diese beiden Varianten unterschiedliches Verhalten gegenüber unterschiedlichen Waferoberflächen zeigen, wie nachfolgend anhand von Figur 6 beschrieben wird.

Die Figur 6 zeigt eine graphische Darstellung zur Veranschaulichung der Kornhöhe und des Kornabstandes in Abhängigkeit von Waferart bzw. Oberflächenart. Verglichen werden Oxid- und Nitrid-Oberflächen bei zwei unterschiedlichen Prozessvarianten, die zu ungefähr gleichen Kornhöhen führen. (Zwei Kombinationen von Verdünnung und Abscheidezeit, nämlich 1:10/30 Minuten und 1:5/15 Minuten, mittlere Kornhöhen zwischen 20 und 27 nm.)

Bezüglich des Kornabstandes fallen aber deutliche Unterschiede auf. Bei der stärkeren Verdünnung und dafür längeren Abscheidezeit wächst auf Nitrid eine weitgehend geschlossene Schicht auf, d.h. der Kornabstand ist gleich Null. Dagegen ist festzustellen, dass bei geringerer Verdünnung und kürzerer Abscheidezeit auf beiden Oberflächenarten isolierte Körner mit vergleichbarem Kornabstand wachsen, die Abscheidung folglich weniger stark abhängig von der Art der Oberfläche ist. Andererseits kann das unterschiedliche Bekeimungsverhalten verschiedener Oberflächen bei stärkerer Verdünnung auch gezielt ausgenutzt werden.

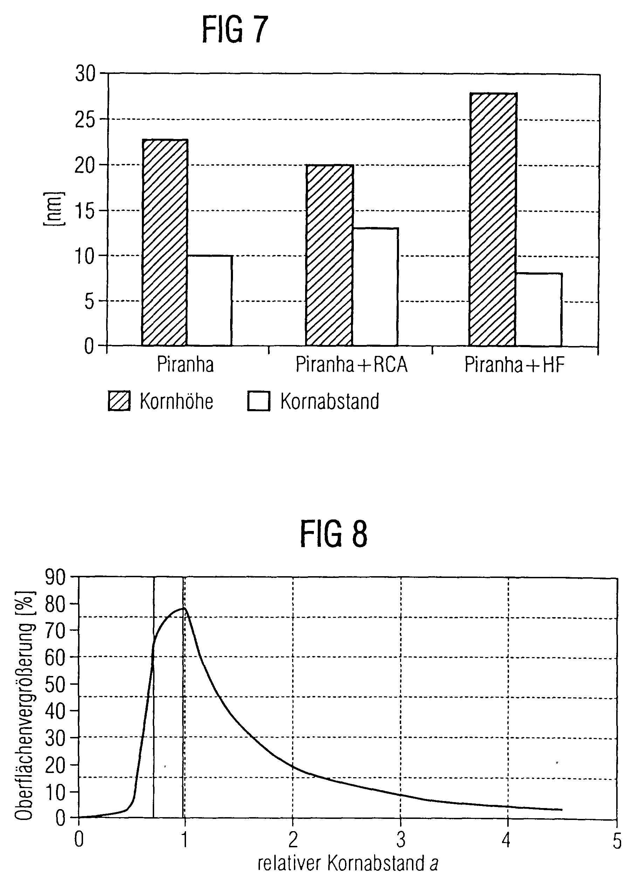

Figur 7 zeigt eine graphische Darstellung zur Veranschaulichung einer Abhängigkeit von Kornhöhe und Kornabstand von einer durchgeführten Art der Vorreinigung. Gemäß Figur 7 wurde eine sogenannte "Piranha"-, eine "Piranha+RCA"- oder eine "Piranha+HF"-Reinigung auf ein Silizium-Substrat angewendet. Auf eine detaillierte Beschreibung dieser herkömmlichen, nasschemischen Reinigungs-Verfahren wird an dieser Stelle verzichtet, da sie dem Fachmann hinlänglich bekannt sind. Gemäß Figur 7 ist die Kornhöhe und der Kornabstand bei Verwendung von Silizium-Substrat-Wafern demzufolge auch von der durchgeführten Vorreinigung abhängig. "Piranha"- und "RCA"-Reinigung hinterlassen ein dünnes nasschemisches Oxid (hydrophil), während die "HF-Dip"-Reinigung zu einer wasserstoffterminierten Siliziumoberfläche ohne Oxid führt (hydrophob). Bei der hydrophoben Vorreinigung treten verhältnismäßig große unregelmäßig geformte Körner auf.

Zusammenfassend ergibt sich dadurch neben den verschiedenen Temperatur-, Druck-, Zeitdauer- und Verdünnungs-Bereichen eine besonders vorteilhafte Prozessparameter-Kombination für eine optimale Oberflächenvergrößerung:

| | |
|---|---|
| Verdünnung | 1:5 |
| Temperatur | 560 Grad Celsius |
| Abscheidezeit | 15 Minuten |
| Prozessdruck | 200 mTorr. |

Zur einfachen Beurteilung der vorstehend beschriebenen Versuchsergebnisse wird nachfolgend ein einfaches theoretisches Modell zur Abschätzung der Oberflächenvergrößerung durch Siliziumkörner beschrieben.

Gemäß diesem einfachen theoretischen Modell wird angenommen, dass halbkugelförmige Körner gleichen Durchmessers auf einer ebenen Oberfläche in einem regelmäßigen quadratischen Gitter angeordnet sind. Der Durchmesser der Halbkugeln ist D, der Abstand der Mittelpunkte der Halbkugeln ist A (, wobei dieser Abstand nicht mit dem Kornabstand der Figuren 3 bis 7 zu verwechseln ist). Man definiert für dieses theoretische Modell den relativen Kornabstand (genauer: relativen Abstand der Kornmittelpunkte) a = A/D, da die relative oder prozentuale Oberflächenvergrößerung nur von dieser Größe abhängt.

Figur 8 zeigt eine graphische Darstellung zur Veranschaulichung dieses theoretischen Modells. Bei einem relativen Kornabstand von a = 2 ist der Abstand der Mittelpunkte doppelt so groß wie der Korndurchmesser, folglich ist der freie Abstand zwischen zwei benachbarten Körnern bzw. Halbkugel-Oberflächen gleich dem Durchmesser. Beim relativen Kornabstand a = 1 berühren sich benachbarte Körner gerade, wodurch sich eine maximale Oberflächenvergrößerung ergibt. Beim relativen Kornabstand a = 1/√2 berühren sich im quadratischen Gitter diagonal gegenüberliegende Körner, d.h. die Körner der jeweils übernächsten Nachbarn. Der relative Kornabstand a = 0 beschreibt eine glatte geschlossene Schicht der Dicke D/2, wodurch sich keine Oberflächenvergrößerung ergibt.

Bei der Verwendung dieses stark vereinfachten theoretischen Modells müssen die in der Realität auftretenden Abweichungen berücksichtigt und deren Einfluss abgeschätzt werden. Die Körner haben zum einen nicht alle den gleichen Abstand und sind nicht regelmäßig angeordnet. Das führt dazu, dass bereits einzelne Körner zusammenwachsen, bevor die dichteste Packung erreicht ist. Die maximale Oberflächenvergrößerung des theoretischen Modells (es berühren sich gerade alle benachbarten Körner) ist daher zumindest mit halbkugelförmigen Körnern nicht erreichbar. Ferner sind die tatsächlichen Halbleiter-Körner nicht halbkugelförmig, sondern zum Teil beinahe kugelförmig. Daraus wiederum ergibt sich eine etwas höhere Oberflächenvergrößerung als im vorstehend beschriebenen theoretischen Modell. Darüber hinaus sind nicht alle Halbleiter-Körner gleich groß, wobei man jedoch eine gute Näherung über das vorstehend beschriebene theoretische Modell erhält, wenn man eine mittlere Korngröße angibt.

In der Realität wird man daher stets etwas unterhalb der in Figur 8 dargestellten Kurve liegen. Insbesondere liegt das Maximum der Kurve bei einem relativen Kornabstand von a etwas größer als 1. Zur Abschätzung der möglichen Oberflächenvergrößerung durch das erfindungsgemäße Einschritt-Verfahren sowie der günstigsten Kornabstände ist dieses theoretische Modell jedoch eine gute Hilfe.

Die Erfindung wurde vorstehend anhand eines LPCVD-Ofens beschrieben. Sie ist jedoch nicht darauf beschränkt und kann vielmehr in allen weiteren zur Verfügung stehenden oder zukünftigen Öfen realisiert werden. Ferner wurde die vorliegende Erfindung anhand von Grabenkondensatoren für DRAM-Speicherschaltungen beschrieben. Die Erfindung ist jedoch nicht darauf beschränkt und umfasst vielmehr alle weiteren Verfahren zur Herstellung von vergrößerten Oberflächen, beispielsweise eingebetteten DRAM- und nicht flüchtigen Halbleiter-Speicherschaltungen.

## Patentansprüche

1. Verfahren zum Erzeugen von Mikro-Rauhigkeiten an einer Oberfläche, wobei ein feinverteiltes Ausbilden von Halbleiter-Körnern (1) aus einem Prozessgas (P) an der Oberfläche (2) unmittelbar in einem Schritt erfolgt.

2. Verfahren nach Patentanspruch 1 ,
**dadurch gekennzeichnet, dass** die Halbleiter-Körner (1) Si- oder Ge-Körner darstellen und das Prozessgas (P) SiH₄ oder GeH₄ aufweist.

3. Verfahren nach Patentanspruch 1 oder 2,
**dadurch gekennzeichnet, dass** das Ausbilden der Halbleiter-Körner (1) in einem Temperaturbereich von 500 Grad Celsius bis 600 Grad Celsius erfolgt.

4. Verfahren nach einem der Patentansprüche 1 bis 3,
**dadurch gekennzeichnet, dass** das Ausbilden der Halbleiter-Körner (1) bei einem Druck von 100 bis 600 mTorr erfolgt.

5. Verfahren nach einem der Patentansprüche 1 bis 4,
**dadurch gekennzeichnet, dass** das Ausbilden der Halbleiter-Körner (1) für eine Zeitdauer von 5 Minuten bis 60 Minuten erfolgt.

6. Verfahren nach einem der Patentansprüche 1 bis 5,
**dadurch gekennzeichnet, dass** die Oberfläche (2) ein Oxid, Nitrid oder Si-Substrat darstellt.

7. Verfahren nach Patentanspruch 6,
**dadurch gekennzeichnet, dass** das Si-Substrat einer Vorreinigung unterworfen wird.

8. Verfahren nach Patentanspruch 7,
**dadurch gekennzeichnet, dass** die Vorreinigung eine Piranha-, RCA- und/oder HF-Dip-Reinigung aufweist.

9. Verfahren nach einem der Patentansprüche 1 bis 8,
**dadurch gekennzeichnet, dass** das Prozessgas (P) eine H₂-Verdünnung in einem Bereich von 1:20 bis 1:0,2 aufweist.

10. Verfahren nach einem der Patentansprüche 1 bis 8,
**dadurch gekennzeichnet, dass** das Prozessgas (P) eine N₂-Verdünnung in einem Bereich von 1:100 bis 1:5 aufweist.
